# EUROPEAN PATENT SPECIFICATION

(11) **EP 3 826 439 B1**
(45) Date of publication and mention of the grant of the patent: **07.01.2026**
(21) Application number: 19209969.5
(22) Date of filing: 19.11.2019
(51) Int. Cl.: H05K 3/42, H05K 3/00

(54) **METHOD OF MANUFACTURING A LAMINATED COMPONENT CARRIER WITH BLIND HOLE HAVING WEDGES FILLED WITH FILLING MEDIUM BY SPUTTERING AND BACK-SPUTTERING**
VERFAHREN ZUR HERSTELLUNG EINES LAMINIERTEN KOMPONENTENTRÄGERS MIT BLINDLOCH MIT RITZEN, DIE DURCH SPUTTERING UND RÜCKSPUTTERING MIT EINEN FÜLLMEDIUM GEFÜLLT SIND
MÉTHODE DE FABRICATION D'UN SUPPORT DE COMPOSANT STRATIFIÉ AVEC TROU BORGNE DOTÉ DE COINS REMPLIS DE PRODUIT DE REMPLISSAGE PAR PULVÉRISATION CATHODIQUE ET RÉTROPULVÉRISATION CATHODIQUE

(43) Date of publication of application: 26.05.2021
(73) Proprietor: AT & S Austria Technologie & Systemtechnik Aktiengesellschaft, 8700 Leoben-Hinterberg (AT)
(72) Inventor: Lopez Blanco, Vanesa, 15127 A Corunha (ES); Preiner, Erich, 8770 St. Michael (AT); Schrei, Martin, 8382 Mogersdorf (AT); Souli, Imane, 8700 Leoben (AT)
(74) Representative: Donatello, Daniele

(56) References cited:
- EP-A2- 1 122 989
- JP-A- 2001 127 155
- STEFANIE BREMMERT ET AL: "Developments in Electroless Copper Processes to Improve Performance in amSAP Mobile Applications", 19 March 2019 (2019-03-19), XP055693998, Retrieved from the Internet <URL:https://www.atotech.com/wp-content/uploads/2019/03/Developments-in-Electroless-Copper-Processes-to-Improve-Performance-in-aMSAP-Mobile-Applications.pdf> [retrieved on 20200512]

## Description

The invention relates to a method of manufacturing a component carrier.

In the context of growing product functionalities of component carriers equipped with one or more electronic components and increasing miniaturization of such components as well as a rising number of components to be mounted on the component carriers such as printed circuit boards, increasingly more powerful array-like components or packages having several components are being employed, which have a plurality of contacts or connections, with ever smaller spacing between these contacts. Removal of heat generated by such components and the component carrier itself during operation becomes an increasing issue. At the same time, component carriers shall be mechanically robust and electrically reliable so as to be operable even under harsh conditions. All these requirements go hand in hand with a continued miniaturization of component carriers and their constituents.

In particular, it may be advantageous to efficiently contact electrically conductive layer structures and/or components mounted on and/or embedded in a component carrier with proper reliability.

Document Stefanie Bremmert ET AL, "Developments in Electroless Copper Processes to Improve Performance in amSAP Mobile Applications", 19 March 2019 (2019-03-19), XP055693998 URL: https://www.atotech.com/wp-content/uploads/2019/03/Developments-in-Electroless-Copper-Processes-to-Improve-Performance-in-aMSAP-Mobile-Applications.pdf, discloses formation of holes in a component carrier through a laser drill, followed by a desmear to remove resin in excess after the laser drill, and by a subsequent activation and electroless copper deposition resulting in conductive vias.

Documents JP 2001 127155 A and EP 1 122 989 A2 disclose via holes formed in one electrically insulating layer followed by a copper plate.

There may be a need to manufacture a component carrier with proper reliability.

According to the invention, a method of manufacturing a component carrier as defined in claim 1 is provided; accordingly, the method comprises laminating a stack comprising at least one electrically conductive layer structure and/or at least one electrically insulating layer structure, forming a blind hole with an exterior tapering section (i.e. an exterior section which tapers inwardly) in the stack, cleaning the blind hole and thereby forming wedges in a bottom portion of the blind hole, thereafter sputtering a filling medium (for example an electrically conductive filling medium) into the blind hole, and back-sputtering at least part of the sputtered filling medium so as to at least partially fill the wedges.

In the context of the present application, the term "component carrier" may particularly denote any support structure which is capable of accommodating one or more components thereon and/or therein for providing mechanical support and/or electrical connectivity. In other words, a component carrier may be configured as a mechanical and/or electronic carrier for components. In particular, a component carrier may be one of a printed circuit board, an organic interposer, and an IC (integrated circuit) substrate. A component carrier may also be a hybrid board combining different ones of the above-mentioned types of component carriers.

In the context of the present application, the term "laminated stack" may particularly denote a sequence of two or more layer structures formed on top of each other by lamination. Thus, the layer structures may be connected by the application of pressure and/or heat.

In the context of the present application, the term "layer structure" may particularly denote a continuous layer, a patterned layer or a plurality of nonconsecutive islands within a common plane.

In the context of the present application, the term "blind hole" may particularly denote a hole extending into, but not entirely through a layer stack or an electrically insulating layer structure. Thus, a blind hole may have a closed bottom. Preferably, the blind hole may be formed as a laser blind hole, i.e. may be created by a laser process.

In the context of the present application, the term "tapering section of the blind hole" may particularly denote a frustoconical exterior portion of the blind hole with slanted side walls. More specifically, a laser blind hole may be a blind hole having the described tapering shape as a result of the energy impact of one or more laser beams which may be irradiated onto the stack or an electrically insulating layer structure thereof. An exterior vertical tapering section may particularly denote a section of the blind hole in an exterior end portion of the stack at which the sidewalls of the stack delimiting the blind hole narrow towards an interior of the blind hole. For instance, such a tapering section may be a substantially frustoconical blind hole portion.

In the context of the present application, the term "wedges" may particularly denote outwardly tapering extensions of a substantially frustoconical blind hole portion extending at a bottom side thereof in a substantially horizontal direction. Said wedges may taper horizontally to thereby form beak-shaped indentations connected to the vertically tapering portion of the blind hole. The wedges may have an outermost lateral peak end extending laterally beyond walls delimiting the tapering section of the blind hole. For instance, such wedges may be circumferentially closed so as to form a disk-shaped arrangement tapering outwardly in a horizontal direction.

In the context of the present application, the term "cleaning" the blind hole may particularly denote a process of removing dust or dirt resulting from a previous laser drilling process or the like, in particular from a bottom portion and/or from sidewalls of the for instance laser drilled tapering blind hole. Such a cleaning procedure may prepare the blind hole for a subsequent supply of an electrically conductive filling medium filling the blind hole partially or entirely. However, such a cleaning may also form artefacts in form of the above-described wedges.

In the context of the present application, the term "sputtering" electrically conductive filling medium may particularly denote applying the filling medium by physical vapour deposition (PVD). This may be done with a physical procedure of applying electrically conductive material to a previously cleaned blind hole. Sputtering may denote a mechanism by which atoms are dislodged from the surface of a source or target material as a result of a collision with high-energy particles. Thus, PVD by sputtering may refer to a technique in which atoms or molecules are ejected from a source or target material by high-energy particle bombardment so that the ejected atoms or molecules can condense on a substrate as a thin film of sputtered material. PVD may denote a process by which a thin film of material is deposited on a surface in particular according to the following sequence of processes: a) the material to be deposited is converted into vapor by physical mechanisms; b) the vapor is transported across a region of low pressure from its source to a surface delimiting the blind hole; and c) the vapor undergoes condensation on the surface to form the sputtered material.

In the context of the present application, the term "back-sputtering" may particularly denote a process of reversing or inverting a previous sputtering process so that, during back-sputtering, electrically conductive filling medium is not provided from an outside of the blind hole into the blind hole, but in contrast to this from a first portion of the blind hole to second portions of the blind hole, and optionally also partially to a volume outside of the blind hole. While sputtering is a material supply process, back-sputtering is a material removal or re-arrangement process.

According to an exemplary embodiment of the invention, a method of manufacturing a component carrier is provided in which the electric reliability can be significantly improved. This can be accomplished by sputtering and subsequently back-sputtering (for example electrically conductive or other solid) filling medium in a previously cleaned laser blind hole having wedges horizontally extending from a bottom portion of the for instance substantially frustoconical blind hole. These wedges are an artefact from a desmear cleaning process which is however highly advantageous in order to properly prepare the blind hole for subsequent filling with solid filling medium. The presence of said wedges may conventionally deteriorate the process and the efficiency of filling the blind hole with electrically conductive filling medium by being a cause for undesired unfilled voids. Descriptively speaking, an exemplary embodiment of the invention firstly applies filling medium into at least part of the blind hole by sputtering, before triggering re-arrangement of at least part of said sputtered material within the blind hole by a back-sputtering process. It has turned out surprisingly that back-sputtering of previously sputtered filling medium in a laser blind hole with desmear-caused wedges may significantly improve the filling performance of the blind hole with (preferably electrically conductive) filling medium. It has furthermore turned out that such a back-sputtering process may contribute to more homogeneously filling part of the wedges and covering sidewalls of the laser blind hole with sputtered material (in particular metal). Thus, a subsequent plating procedure or the like which may be carried out for further filling the blind hole with additional filling medium can be carried out in a more efficient way.

In the following, further exemplary embodiments of the method will be explained.

In an embodiment, the line space ratio of and between traces of the component carrier is below 10 µm/10 µm, in particular below 5 µm/5 µm, more particularly below 4 µm/4 µm. In the context of the present application, the term "line space ratio" may particularly denote a characteristic value of a component carrier indicating a dimension of the lines in a horizontal direction, i.e. of the electrically conductive traces, in comparison with a horizontal space in between two adjacent traces, i.e. the space. A line space ratio of 5 µm/5 µm may thus indicate a line width of 5 µm and a space between adjacent traces of also 5 µm. It has turned out that with the mentioned very small line space values, issues with the filling of laser blind holes by sputtering electrically conductive filling medium such as copper becomes more and more difficult. This holds in particular when the laser drilled blind hole is cleaned by a desmearing process before sputtering, since the correspondingly created wedges may be poorly accessible by a sputtering process, in particular at the mentioned small dimensions. However, by combining sputtering with back-sputtering, it has turned out that even with said very small line space ratios, a proper filling of the blind hole may be accomplished.

In an embodiment, the electrically conductive filling medium is free of palladium. Palladium is a material which may disturb PCB (printed circuit board) production. When however depositing a seed structure of sputtered copper, it is an inherent property of sputtering processes that the created copper material does not comprise any significant amount of palladium, in particular less than 1 ppm palladium.

In an embodiment, the electrically conductive filling medium comprises or consists of sputtered material. After having deposited electrically conductive filling medium in the blind hole by sputtering and subsequent back-sputtering, such a fundament of copper material forms a proper basis of continuing the filling procedure by a plating process, in particular galvanically plating. As a result, a substantially void-free filling of the blind hole with an electrically conductive filling medium such as copper may be achieved.

In an embodiment, the tapering section of the laser via has a frustoconical shape. Thus, the tapering section may have slanted straight sidewalls. It goes without saying that, due to unavoidable tolerances of each PCB manufacturing process, there may be slight deviations from a purely frustoconical shape of the tapering portion of the blind hole.

In an embodiment, the (in particular horizontal) bottom surface of the blind hole is delimited by an electrically conductive layer structure of the stack. Correspondingly, the method may comprise the process of forming a bottom of a laser via by an electrically conductive layer structure. Such an electrically conductive layer structure may also serve as a stop layer for the laser drilling process. In other words, a bottom surface of the blind hole may be delimited by a buried electrically conductive layer structure, such as a patterned copper foil or a pad of an embedded component. It has turned out as particularly appropriate to delimit the bottom of the blind hole with an electrically conductive layer structure. The latter may serve as a stop layer during the laser drilling, because laser light may be reflected from an electrically conductive layer structure which is exposed by laser drilling through an electrically insulating layer structure (such as a prepreg layer) above.

In an embodiment, a bottom of the blind hole has one of the group consisting of a flat shape and a concave shape. Preferred may be a concave shape of the bottom of the blind hole, since this may promote re-arrangement of filling medium from the bottom into the wedges during back-sputtering. Particularly preferred may be a combination of a concave bottom with a convex depot of sputtered filling medium on the concave bottom, since this may provide a double-effect of synergistically promoting highly efficient rearrangement of filling medium into the wedges during back-sputtering.

In an embodiment, the method may comprise carrying out a treatment of a bottom of the blind hole, in particular an etching treatment, for creating a concave surface at the bottom of the blind hole. For instance, said etching treatment may be carried out as part of the above-described desmear process, or before or after said desmear process. As mentioned above, formation of a concave bottom surface of the blind hole may promote back-sputtering of filling medium into the wedges.

In an embodiment, the wedges form a circumferentially closed recess. In other words, an annular void may be formed in the bottom region of the blind hole.

In an embodiment, the wedges taper horizontally towards a lateral sharp tip. Such a tip, which may constitute a laterally outermost end of the blind hole, may render filling of the wedges with electrically conductive material particularly difficult. It has turned out that the concept of back-sputtering can fulfil this difficult task.

In an embodiment, the electrically conductive filling medium comprises or consists of copper. The filling of the blind hole with copper material may render the filling procedure properly compatible with PCB technology.

In an embodiment, the component carrier comprises an electrically conductive plating layer extending along at least part of a horizontal surface of the stack outside of the blind hole and along at least part of the electrically conductive filling medium in the blind hole. After having re-arranged the sputtered material to coat or line a significant portion of the wall delimiting the blind hole by back-sputtering, filling of the blind hole with electrically conductive material may be continued with plating. For instance, said electrically conductive plating layer may be formed by galvanic plating. During such a galvanic plating process, the previously back-sputtered electrically conductive filling medium may serve as an electrically conductive base for the galvanic plating.

In an embodiment, the component carrier comprises an electrically conductive structure filling at least part of a volume between said plating layer and an exterior of the blind hole. In particular, said electrically conductive structure comprises or consists of at least one further plating structure. It is for instance possible that said electrically conductive structure is composed of a plurality of stacked further plating structures.

In an embodiment, the electrically conductive filling medium substantially continuously lines walls delimiting the tapering section and the wedges. Such a preferably uninterrupted and/or homogeneous coating of the walls delimiting the blind hole may simplify a subsequent galvanic filling of the rest of the blind hole and may prevent the formation of undesired voids of the metal filled blind hole.

In an embodiment, the at least one electrically insulating layer structure comprises filler particles. Such filler particles may also partially delimit wall sections defining the tapering section and/or the wedges. Said filler particles may be advantageous for adjusting physical properties of the component carrier, for instance for increasing thermal conductivity, for shielding electromagnetic radiation, for reinforcing the stack, etc. However, such filler particles may also increase a roughness of the wall delimiting the blind hole when being exposed by the laser drilling. Surprisingly, the described concept of back-sputtering may allow also coping with the presence of filler particles and may in particular allow to fill tiny desmear-caused wedges with rough walls which may be partially delimited by for instance substantially spherical filler particles with sputtered electrically conductive material.

In an embodiment, the method comprises back-sputtering at least part of the sputtered electrically conductive filling medium so as to at least partially cover the tapering section. Hence, wall coverage of both the wedges and the tapering portion may be improved with the back-sputtering.

In an embodiment, the method comprises carrying out the sputtering so that the electrically conductive filling medium has a convex shape on a bottom of the blind hole after the sputtering and before the back-sputtering. For instance, this may be achieved by vertically sputtering electrically conductive filling medium into the blind hole. Such a convex depot of electrically conductive material at the (in particular concave or flat) bottom surface of the blind hole has turned out as a proper basis for coating a significant portion of the wall of the blind hole by back-sputtering. Descriptively speaking, back-sputtering based on a convex depot of electrically conductive material may promote a broad spatial distribution of the back-sputtered electrically conductive material over substantially an entire angular range of 180° above a flat bottom of the blind hole, and thus also into the wedges. In other words, the convex curvature may promote a reflection of metal atoms to different angles during a subsequent back-sputtering process. In a preferred embodiment, the reflection of the metal atoms is enhanced by a concave shape of the bottom, and additionally enhanced by a convex shape of the deposited copper.

In an embodiment, the method comprises forming the tapering section by laser drilling. Laser drilling may be accomplished with one or more laser shots which will remove or burn away electrically insulating material of the stack above an embedded electrically conductive layer structure. However, such laser drilling may create dust or dirt in particular on a bottom of the laser blind hole, which can be removed for instance by a desmearing process.

Correspondingly, the method may comprise the process of cleaning the laser bridge blind hole by a desmear process. In the context of the present application, the term "desmear process" may particularly denote a chemical process of removing dust or dirt in a bottom region (and optionally also on sidewalls) of a laser drilled blind hole. More specifically, a desmear process may be a process of removing surface material and may be carried out after laser drilling the stack of the component carrier to be manufactured. Such a material removal process may at least partially remove residues of dielectric component carrier material remaining at sidewalls of the drilled holes after the drilling. More generally, desmearing may define a process of cleaning a drilled hole. While desmearing properly prepares or conditions the blind hole for subsequent supply of electrically conductive material into the blind hole, it may also have the side effect of creating the above-mentioned wedges. When forming a blind hole by laser drilling, dregs or smear may be generated in the blind hole which may render subsequent copper plating difficult. Therefore, desmear treatment for at least partially removing smear may be performed. For instance, desmear treatment methods may use potassium permanganate and/or sodium permanganate. It is also possible to apply ultrasonic waves during a desmear process.

In an embodiment, the method comprises cleaning by a wet desmear process. A wet desmear process may involve wet chemistry for removing dirt or dust created by laser drilling from exposed surfaces and in particular a bottom surface of the laser blind hole. Descriptively speaking, such a wet chemistry may etch away said residues from a laser drilling through organic material such as prepreg, FR4, epoxy resin, glass fibres, etc.

In an alternative embodiment of the invention, the method comprises back-sputtering by dry etching, in particular dry plasma treatment. The actual back-sputtering may be induced by reversing or inverting the previous sputtering process. Hence, after having formed the electrically conductive filling medium in the blind hole with the wedges by a sputtering process, said sputtering process may be subsequently inverted for removing the previously sputtered electrically conductive filling medium at least partially out of the blind hole by dry etching. Descriptively speaking, the application of a plasma may remove electrically conductive filling medium which has been previously sputtered onto an exposed surface of the desmeared laser blind hole. In particular, previously sputtered material can be re-oriented from walls delimiting the desmeared laser blind hole into the wedges. It has turned out that this re-arrangement process is particularly advantageous for substantially completely filling the blind hole in a subsequent plating process or the like with electrically conductive filling medium. Thus, a dry etching process, preferably a plasma treatment process, may invert the effect of the previous sputtering and may thereby improve the electric performance of the component carrier being produced.

In an alternative embodiment of the invention, the method comprises back-sputtering by sputtering with inverse voltage. For instance, a positive voltage may be applied during sputtering, whereas a negative voltage may be applied during back-sputtering. By inverting an electric voltage used for creating the sputtered electrically conductive filling medium, the sputtering process may be reversed, and the sputtered material may be removed from the deposited regions in the blind hole.

In an embodiment, the method comprises carrying out multiple alternating sequences of sputtering and back-sputtering. For instance, it may be possible to switch between a sputtering mode and a back-sputtering mode multiple times (i.e. for instance carrying out at least two, in particular at least three sputtering processes and at least two, in particular at least three, back-sputtering processes). For example, a corresponding processing sequence may be "sputtering - back-sputtering - sputtering - back-sputtering - ...". It has turned out that an alternating sequence of material deposition and material re-arrangement processes may allow to iteratively improve the homogeneity of the surface coverage with sputtered electrically conductive filling medium both in the wedges and in the tapering section of the blind hole. In particular, it has turned out to be advantageous to repeat the alternating back-sputtering sequence at least twice, in particular between two times and five times.

In an embodiment, the component carrier comprises a stack of at least one electrically insulating layer structure and at least one electrically conductive layer structure. For example, the component carrier may be a laminate of the mentioned electrically insulating layer structure(s) and electrically conductive layer structure(s), in particular formed by applying mechanical pressure and/or thermal energy. The mentioned stack may provide a plate-shaped component carrier capable of providing a large mounting surface for further components and being nevertheless very thin and compact.

In an embodiment, the component carrier is shaped as a plate. This contributes to the compact design, wherein the component carrier nevertheless provides a large basis for mounting components thereon. Furthermore, in particular a naked die as example for an embedded electronic component, can be conveniently embedded, thanks to its small thickness, into a thin plate such as a printed circuit board.

In an embodiment, the component carrier is configured as one of the group consisting of a printed circuit board, a substrate (in particular an IC substrate), and an interposer.

In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming through holes through the laminate, for instance by laser drilling or mechanical drilling, and by filling them with electrically conductive material (in particular copper), thereby forming vias as through hole connections. Apart from one or more components which may be embedded in a printed circuit board, a printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier. A substrate may be a, in relation to a PCB, comparably small component carrier onto which one or more components may be mounted and that may act as a connecting medium between one or more chip(s) and a further PCB. For instance, a substrate may have substantially the same size as a component (in particular an electronic component) to be mounted thereon (for instance in case of a Chip Size Package (CSP)). More specifically, a substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the substrate and can be used to provide electrical, thermal and/or mechanical connections of housed components or unhoused components (such as bare dies), particularly of IC chips, with a printed circuit board or intermediate printed circuit board. Thus, the term "substrate" also includes "IC substrates". A dielectric part of a substrate may be composed of resin with reinforcing particles (such as reinforcing spheres, in particular glass spheres).

The substrate or interposer may comprise or consist of at least a layer of glass, silicon (Si) or a photoimageable or dry-etchable organic material like epoxy-based build-up material (such as epoxy-based build-up film) or polymer compounds like polyimide, polybenzoxazole, or benzocyclobutene-functionalized polymers

In an embodiment, the at least one electrically insulating layer structure comprises at least one of the group consisting of resin (such as reinforced or non-reinforced resins, for instance epoxy resin or bismaleimide-triazine resin), cyanate ester resins, polyphenylene derivate, glass (in particular glass fibers, multi-layer glass, glass-like materials), prepreg material (such as FR-4 or FR-5), polyimide, polyamide, liquid crystal polymer (LCP), epoxy-based build-up film, polytetrafluoroethylene (PTFE, Teflon), a ceramic, and a metal oxide. Reinforcing structures such as webs, fibers or spheres, for example made of glass (multilayer glass) may be used as well. Although prepreg particularly FR4 are usually preferred for rigid PCBs, other materials in particular epoxy-based build-up film or photoimageable dielectric material may be used as well. For high frequency applications, high-frequency materials such as polytetrafluoroethylene, liquid crystal polymer and/or cyanate ester resins, low temperature cofired ceramics (LTCC) or other low, very low or ultra-low DK materials may be implemented in the component carrier as electrically insulating layer structure.

In an embodiment, the at least one electrically conductive layer structure comprises at least one of the group consisting of copper, aluminum, nickel, silver, gold, palladium, and tungsten. Although copper is usually preferred, other materials or coated versions thereof are possible as well, in particular coated with supra-conductive material such as graphene.

At least one component, which can be optionally surface mounted on and/or embedded in the stack, can be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an optical element (for instance a lens), an electronic component, or combinations thereof. For example, the component can be an active electronic component, a passive electronic component, an electronic chip, a storage device (for instance a DRAM or another data memory), a filter, an integrated circuit, a signal processing component, a power management component, an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be embedded in or mounted on the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be a substrate, an interposer or a further component carrier, for example in a board-in-board configuration. The component may be surface mounted on the component carrier and/or may be embedded in an interior thereof. Moreover, also other components, in particular those which generate and emit electromagnetic radiation and/or are sensitive with regard to electromagnetic radiation propagating from an environment, may be used as component.

In an embodiment, the component carrier is a laminate-type component carrier. In such an embodiment, the component carrier is a compound of multiple layer structures which are stacked and connected together by applying a pressing force and/or heat.

After processing interior layer structures of the component carrier, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

After having completed formation of a stack of electrically insulating layer structures and electrically conductive layer structures, it is possible to proceed with a surface treatment of the obtained layer structures or component carrier.

In particular, an electrically insulating solder resist may be applied to one or both opposing main surfaces of the layer stack or component carrier in terms of surface treatment. For instance, it is possible to form such as solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of a component carrier. If such exposed electrically conductive layer structures are left unprotected, then the exposed electrically conductive component carrier material (in particular copper) might oxidize, making the component carrier less reliable. A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), gold (in particular Hard Gold), chemical tin, nickel-gold, nickel-palladium, Electroless Nickel Immersion Palladium Immersion Gold (ENIPIG), etc.

The aspects defined above and further aspects of the invention are apparent from the examples of embodiment to be described hereinafter and are explained with reference to these examples of embodiment.
Figure 1 to Figure 6 illustrate cross-sectional views of structures obtained during carrying out a method of manufacturing a component carrier, shown in Figure 6, according the invention.
Figure 7 and Figure 8 illustrate cross-sectional views of structures obtained during carrying out a method of manufacturing a component carrier according to an exemplary embodiment of the invention.
Figure 9 is a three-dimensional view of an image showing the geometry of a via bottom after a wet desmear process following laser drilling.
Figure 10 illustrates a higher deposition rate of an electrically conductive filling medium in a wedge of a blind hole obtained by a combination of sputtering and back-sputtering.

The illustrations in the drawings are schematic. In different drawings, similar or identical elements are provided with the same reference signs.

Before referring to the drawings, exemplary embodiments will be described in further detail, some basic considerations will be summarized based on which exemplary embodiments of the invention have been developed.

According to an exemplary embodiment of the invention, a sequence of sputtering and back-sputtering may be applied following laser drilling and desmear cleaning of a blind hole of a PCB (printed circuit board) stack in order to better fill wedges of the blind hole with electrically conductive filling medium. The wedges may be formed at a bottom of a tapering blind hole due to the desmear process. Problems resulting from shadowing and overhang during laser drilling and desmearing may be overcome in terms of filling the blind hole with electrically conductive filling medium such as copper by a field inversion after sputtering, to thereby accomplish back-sputtering. After creating holes in a stack by laser drilling through a resin layer, a wet edge desmear process may properly clean the blind hole from dust or dirt, but may also create wedges in the bottom of the blind hole. When sputtering copper, the wedges may be improperly filled with such an electrically conductive filling medium. When back-sputtering, the sputter process may be inverted and the previously sputtered material may be forced to move away from the hole by dry etching, which will cause the copper material to also move into the wedges and on the sidewalls of the blind hole.

Particularly advantageously may be a multiple switching alternating between a sputter mode and a back-sputter mode to even better promote filling of wedges and covering slanted sidewalls with the electrically conductive filling medium.

When a very small line space ratio is desired (for instance below 5 µm/5 µm) and/or when the via diameter is very small (in particular less than 50 µm), sputtering is without real alternative for coating dielectric walls of a blind hole with a metal, since electroless deposition does not work properly under these circumstances. Furthermore (and in contrast to electroless deposition processes), sputtering is a process being capable to create a substantially palladium-free electrically conductive filling medium such as copper. Since many PCB processes are not compatible with palladium, this is a big advantage in terms of the manufacturing process.

An additional advantage of the sputtering process in contrast to electroless deposition is that no additional seed layer is necessary to entirely fill the micro via. A palladium seed layer may be fully replaced by the sputtered copper layer.

An exemplary embodiment of the invention implements post etching for metal film deposition in geometrical singularities to enhance through-hole and via wedges coverage. Making use of a back-sputtering process (in particular accomplished by dry etching) to deposit a metal layer on areas of difficult access of a laser blind hole (such as via walls, wedges, the middle portion of the through-hole, etc.) such a procedure can be carried out. After desmear, wedges may be formed on the sides of the via bottom. These, as well as fillers on the via walls may act as a shadow mask that makes it difficult to deposit metal layers on these areas by a physical vapour deposition (PVD) process when taken alone. However, a back-sputtering stage following a PVD or sputtering process has turned out to contribute to significantly improve the coverage of these areas with deposited metallic material either the via bottom. This may be made after sputtering of the panel sides. Depending on the target metal layer thickness after sputtering, the amount of a metal layer to be removed during the back-sputtering process for good coverage performance can be taken into consideration in the deposition stage. As well, it may be advantageous to carry out a two times sputtering process with a back-sputtering process in between, to further improve the performance.

Exemplary embodiments of the invention may make it possible to sputter laser holes with higher aspect ratio. Furthermore, this may ensure an improved homogeneous thickness distribution in the vias. In particular, it may be highly advantageous to make use of a wet desmear process in combination with a dry deposition ensuring a good coverage of the deposited film.

Exemplary applications of exemplary embodiments of the invention are the manufacture of miniaturized component carriers such as IC (integrated circuit) substrates, and may have in particular advantages for high frequency applications.

According to exemplary embodiments of the invention, a post etching procedure may be carried out for depositing a metal film in geometrical singularities to enhance coverage of via wedges with an electrically conductive filling medium. Thus, to overcome the challenge of poorly filled wedges, a gist of an exemplary embodiment of the invention is to combine sputtering with subsequent back-sputtering.

In an embodiment, the metal-metal interface may engender a continuous film formation and thus will not alter the intended curvature. It may also be possible to use a combination of high kinetic and thermal energy to increase metal atom diffusion.

According to exemplary embodiment of the invention, a discontinuous sputter-deposition of a metal thin film in a via configuration may be carried out.

In addition, multiple experimental procedures may be adopted to overcome the above-described challenges:
1. It may be possible to apply a pre-micro etching process to take advantage of the concave shape of the bottom surface of the via configuration, which may contribute to the reverse sputtering at different angles.
2. It may be possible to use high kinetic and thermal energies to increase distribution of the deposited metal atoms.

As a result, a continuous and homogeneous deposition of a metal film in a via configuration may be obtained. With the obtained vias, a lower opening of the bottom surface may be achieved. Reverse sputtering may be carried out advantageously for re-arranging previously sputtered material. In particular, it may be possible to take advantage of the convex shape of the sputtered metal in combination with a concave shape of a bottom surface of the blind hole to increase the reverse sputtering yield. A high kinetic and thermal input energy may be applied to increase diffusion of metal atoms to the less handled surfaces.

For laser drilled vias, after desmear, wedges may be formed on the sides of the via bottom. These areas are of difficult to access for the deposited metal during a Physical Vapor Deposition (PVD) or sputtering process. Moreover, the presence of fillers on the via walls can act as a shadow mask that makes it difficult to sputter below these areas. In order to overcome such and/or other shortcomings, exemplary embodiments may make use of a back-sputtering (preferably by dry etching) process to homogenize the metal layer deposition on the areas of difficult access and with geometrical singularities. This may ensure an improved homogenous filling medium distribution in the vias. In an embodiment, there is also the possibility of making use of a wet desmear process in combination with a dry deposition for ensuring a good coverage of the deposited film.

Exemplary applications of exemplary embodiments of the invention are in particular all component carriers using SAP (semi-additive processing) technology with low dielectric roughness requirement (for instance 5G applications, radar systems, satellite systems, fan-out packages, etc.). In particular, exemplary embodiments of the invention may be advantageous for all fine line applications below 10 µm, i.e. with low line width and low space.

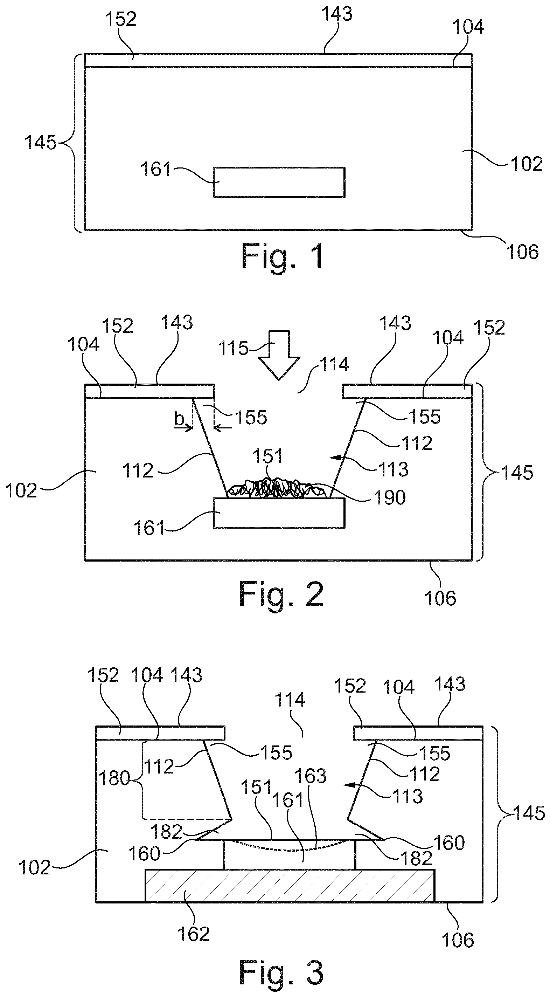

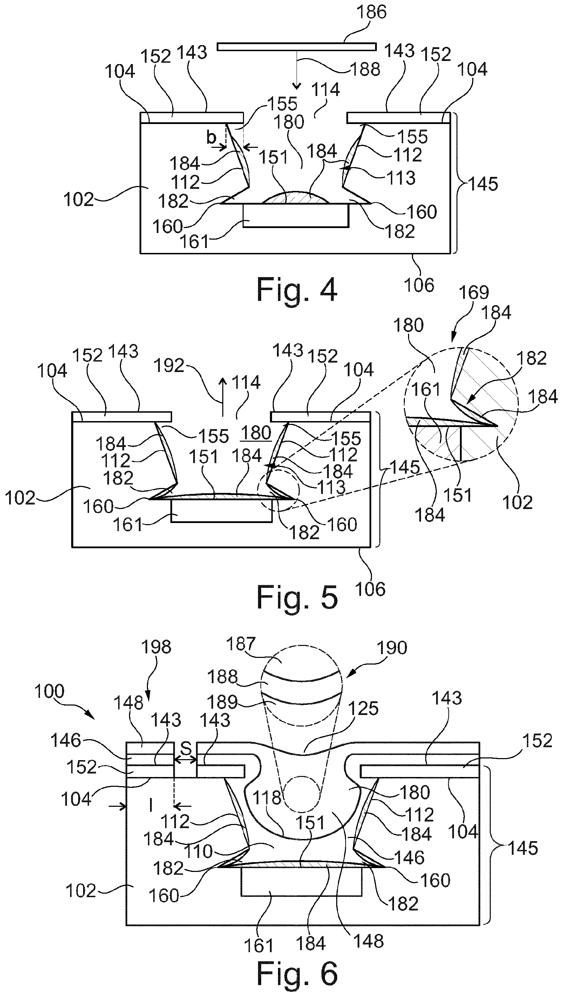

Figure 1 to Figure 6 illustrate cross-sectional views of structures obtained during carrying out a method of manufacturing a component carrier 100 according to an exemplary embodiment of the invention, shown in Figure 6. The method includes the formation of a laser blind hole 113 by a laser shot treatment from a top side and the subsequent filling of the laser blind hole 113 with electrically conductive filling medium 184, with a plating layer 146 and with an electrically conductive structure 148.

**Figure 1** shows a laminated layer stack 145 comprising electrically conductive layer structures 152, 161 and an electrically insulating layer structure 102. Lamination means that stack 145 has been formed by connecting layer structures 152, 161, 102 by the application of pressure and/or heat.

First electrically conductive layer structure 152 is arranged on an upper main surface 104 of electrically insulating layer structure 102. Second electrically conductive layer structure 161 is embedded in an interior of the electrically insulating layer structure 102, i.e. between the upper main surface 104 and a lower main surface 106 of electrically insulating layer structure 102. The first electrically conductive layer structure 152 may be a laminated copper foil. Thus, the first electrically conductive layer structure 152 is a continuous layer. The first electrically conductive layer structure 152 may have a thickness of less than 12 µm, in particular less than 5 µm, for example in a range between 2 µm and 3 µm. The second electrically conductive layer structure 161 may be a patterned copper layer. Hence, the second electrically conductive layer structure 161 may be a capture pad or a buried trace. The second electrically conductive layer structure 161 may have a thickness of less than 10 µm, in particular less than 5 µm, for instance in a range between 2 µm and 3 µm.

In the shown embodiment, the electrically insulating layer structure 102 may comprise resin (in particular epoxy resin), optionally comprising reinforcing particles such as glass fibers or glass spheres. For example, the electrically insulating layer structure 102 may be a thin core or a build-up layer. For instance, a vertical thickness of the electrically insulating layer structure 102 may be less than 180 µm, in particular less than 110 µm, for instance in a range between 10 µm and 60 µm. With such thin cores, reliability issues are particularly pronounced.

A horizontal surface of stack 145 is denoted with reference numeral 143.

Referring to **Figure 2****,** a laser blind hole 113 is formed by carrying out a laser shot 115 irradiated onto horizontal surface 143. Laser processing may be carried out by an appropriate laser source, for instance by a UV laser.

The laser shot 115 forms a window 114 or through hole extending through the first electrically conductive layer structure 152 on the upper main surface 104 of the electrically insulating layer structure 102. Thus, the first electrically conductive layer structure 152 is provided with window 114 defining an outer end of the blind hole 113. Furthermore, the laser shot 115 removes material of the electrically insulating layer structure 102 below window 114 and thereby exposes the second electrically conductive layer structure 161. The exposed portion of the second electrically conductive layer structure 161 forms a bottom 151 of blind hole 113. In other words, the bottom 151 of the blind hole 113 is delimited by the second electrically conductive layer structure 161. The tapering blind hole 113 is laterally delimited by inwardly tapering sidewalls 112.

As shown in Figure 2 as well, a lateral overhang 155 may be formed between the first electrically conductive layer structure 152 next to the window 114 and the electrically insulating layer structure 102 in which the major portion of the blind hole 113 is formed. Preferably, a dimension, b, of the overhang 155 is no more than 10 µm. This can be adjusted by correspondingly adjusting the parameters of the laser shot 115 in terms of energy, duration, etc.

As shown in Figure 2, bottom 151 of the blind hole 113 delimited by electrically conductive layer structure 161 may be covered with residues 190 created by laser drilling of the resin material of electrically insulating layer structure 102. The residues 190 may have an undesired impact when filling the blind hole 113 with electrically conductive material, as described below.

In order to obtain the structure shown in **Figure 3****,** the formed blind hole 113 may be cleaned by wet desmearing. This may remove the residues 190, but may also result in the formation of artefacts in form of wedges 182 in a bottom portion of the blind hole 113. The wedges 182 extends outwardly from bottom 151 of an exterior tapering section 180 of the blind hole 113. As can be taken from Figure 3, carrying out the wet etching desmear process, the residues 190 may be removed from the bottom 151 of the blind hole 113. However, this may create said wedges 182, as shown in Figure 3.

Although not shown in Figure 3, the wedges 182 form a circumferentially closed annular recess. Shown in Figure 3 is that the wedges 182 taper laterally outwardly towards a lateral sharp tip 160 defining a laterally outermost end of the blind hole 113. The wedges 182 are beak-shaped. The formation of the tiny narrowing wedges 182 makes the substantially complete filling of the blind hole 113 with electrically conductive material difficult.

In addition, Figure 3 schematically illustrates that a component 162 can be embedded in the stack 145. For example, the component 162 may be an embedded semiconductor chip which may be contacted by the electrically conductive layer structure 161. For example, the latter may be a pad of the component 162. Thus, blind hole formation and filling with electrically conductive material (as described below) may be carried out for electrically contacting and/or thermally connecting (in particular for heat removal) embedded component 162. For the sake of simplicity, the optional embedded component 162 is not shown in the other figures, but may be optionally present in each of the other figures.

As indicated schematically in Figure 3 with reference sign 163, the via bottom 151, without residues 190, may have a concave shape. This shape may be due to the laser drilling and due to an optional, but highly advantageous additional etching procedure: Prior to sputtering (compare Figure 4), the wet desmear procedure may have a micro-etching process to create or further promote a concave shape of the bottom surface of the laser via. Said cleaning step (increasing the concave shape of bottom 151) is preferably carried out before the sputtering and can be done to get rid of the residue 190, occurring after forming the via with the laser, while also forming or intensifying said concave shape of the bottom 151.

In order to obtain the structure shown in **Figure 4****,** electrically conductive filling medium 184 may be sputtered by Physical Vapor Deposition (PVD) into the blind hole 113. The electrically conductive filling medium 184 may be copper. Thus, in a sputtering process using a sputtering device 186, electrically conductive material such as copper is applied from an exterior of the blind hole 113 into the blind hole 113, as indicated by an arrow 188. As shown, such copper material may be formed on part of the sidewalls and part of the bottom of the blind hole 113 but will not properly fill the wedges 182.

As shown in Figure 4, the sputtering process can be controlled so that the electrically conductive filling medium 184 has a convex shape on bottom 151 of the blind hole 113 after the sputtering. For instance, such a convex shape may be promoted by a substantially vertical sputtering process (compare reference sign 188). Such a convex shape may also be promoted by an optional additional plasma treatment which may be carried out after sputtering, thereby inducing back-sputtering of already deposited material. For a subsequent back-sputtering procedure, said convex shape of the sputtered electrically conductive filling medium 184 in combination with a preferably concave shape of bottom 151 of the blind hole 113 (compare description referring to Figure 3) may be particularly advantageous for subsequent filling the wedges 182 with electrically conductive material.

In order to obtain the structure shown in **Figure 5****,** back-sputtering of previously sputtered electrically conductive filling medium 184 may be carried out so as to at least partially fill the wedges 182 by re-arranging sputtered metal. This is indicated schematically in Figure 5 by reference sign 192 showing an arrow being oriented antiparallel to the arrow 188 of Figure 4. Preferably, said back-sputtering may be carried out with plasma. Advantageously, the back-sputtering process may be executed by sputtering with an inverse electric voltage (for instance a negative voltage) as compared to an electric voltage (for instance a positive voltage) used during the previously carried out sputtering process. In order to render the re-arrangement of the sputtered material as efficient as possible, it may be possible to carry out multiple alternating sequences of sputtering and back-sputtering. The convex curvature of the electrically conductive medium 184 directly after sputtering (see Figure 4) in combination with a preferably concave shape of a bottom 151 (which may be defined by a capture pad) of the blind hole 113 (see Figure 3) may promote a reflection of metal atoms to different angles during back-sputtering.

As shown in a detail 169, the described sputtering/back-sputtering procedure results in a substantially homogeneous coverage of the walls delimiting the blind hole 113 with electrically conductive medium 184. Thus, filling of the wedges 182 with the previously sputtered electrically conductive filling medium 184 may be significantly improved by applying the back-sputtering process. Descriptively speaking, by plasma treatment, previously sputtered electrically conductive filling medium 184 may be re-oriented from the different portions of the blind hole 113 and may partially leave the blind hole 113. However, highly advantageously, it has surprisingly turned out that back-sputtering will also fill at least partially the wedges 182 with back-sputtered electrically conductive filling medium 184. As can be taken from Figure 5, the electrically conductive filling medium 184 substantially continuously lines walls delimiting the tapering section 180 and the wedges 182. As can be seen in Figure 5 as well, the back-sputtering of the previously sputtered electrically conductive filling medium 184 may also be controlled so as to cover walls of the tapering section 180.

Referring to **Figure 6****,** an electrically conductive plating layer 146 is formed which extends along a horizontal surface 143 of the stack 145 outside of the blind hole 113 and along the electrically conductive filling medium 184 in the blind hole 113. Furthermore, an electrically conductive structure 148 fills a volume between the plating layer 146 and an exterior of the blind hole 113. The electrically conductive structure 148 comprises one or more further plating structures. The plating layer 146 and the electrically conductive structure 148 may be formed by carrying out respecting plating procedures, in particular galvanic plating.

Exposed surfaces of the back-sputtered electrically conductive filling medium 184, and optionally portions of the sidewalls 112, the bottom wall 151 of the second electrically conductive layer structure 161 as well as the first electrically conductive layer structure 152 are covered by the plating layer 146 of electrically conductive material such as copper. As shown, the electrically conductive plating layer 146 extends along horizontal surface 143 of the stack 145 outside of the blind hole 113 and along an entire exposed surface of the blind hole 113. As shown as well, the plating layer 146 is formed to be delimited by an upper demarcation surface 118 oriented upwardly. Forming the electrically conductive plating layer 146 may be carried out by galvanic plating, preferably following the described back-sputtering process.

In the region of the narrowest portion of the laser blind hole 113, i.e. at bottom 151, a substantially horizontal bridge structure 110 is formed as a portion of the plating layer 146 connecting opposing portions of the electrically conductive filling medium 184 formed on the tapering sidewalls 112 and in the wedges 182. A concave upper limiting surface of the plating layer 146 corresponds to the demarcation surface 118.

The electrically conductive structure 148 fills a major part between the demarcation surface 118 and the upper main surface of the component carrier 100. This can be done by carrying out one or more further galvanic plating procedures following the previous plating procedure of forming the plating layer 146. Thereby, multiple further plating structures 187, 188, 189 may be formed, as shown in a detail 190, as constituents of structure 148. Thus, the component carrier 100 according to Figure 6 can be obtained by carrying out one or more further plating procedures. Thereby, the structure 148, which may for instance consist of copper, can be obtained. In the shown embodiment, a small dip 125 remains at an upper side of the shown component carrier 100. In other embodiments, the structure 148 fills the remaining recess above the demarcation surface 118 almost completely.

In the shown embodiment, the illustrated component carrier 100 can be a laminate-type plate-shaped component carrier 100 such as a printed circuit board (PCB).

Figure 6 also illustrates that the exterior electrically conductive layer structure 152, the plating layer 146 and the electrically conductive structure 148 may be commonly patterned on a horizontal surface of the electrically insulating layer structure 102 outside of the blind hole 113 so as to form a stacked layer sequence forming an electrically conductive trace 198. Thus, at least one electrically conductive trace 198 used for connection purposes can be formed simultaneously with the filling of the blind hole 113. The described manufacturing process is compatible with and may result in a very small line space ratio of preferably below 4 µm/4 µm. According to Figure 6, determination of the line space ratio can be made by calculating a ratio between a line width, l, of trace 198 and a spacing, s, between adjacent lines or traces.

The component carrier 100 illustrated in Figure 6 shows a geometry of the blind hole 113 which has an exterior tapering section 180 and wedges 182 in a bottom portion. The illustrated blind hole 113 has a frustoconical shape with the beak-shaped wedges 182. As shown as well, the bottom of the blind hole 113 is delimited by the electrically conductive layer structure 152. The electrically conductive filling medium 184 partially fills the tapering section 180 and the wedges 182. Due to the described manufacturing process (implementing sputtering rather than electroless deposition for initiating filling of the blind hole 113 with an electrically conductive filling medium 184), the electrically conductive filling medium 184 is free of palladium. Thus, the electrically conductive filling medium 184 comprises sputtered material in combination with galvanically plated material. As shown in Figure 6, the process of sputtering (see Figure 4) and back-sputtering (Figure 5) may significantly improve the filling of the laser via 113 with electrically conductive filling medium 184.

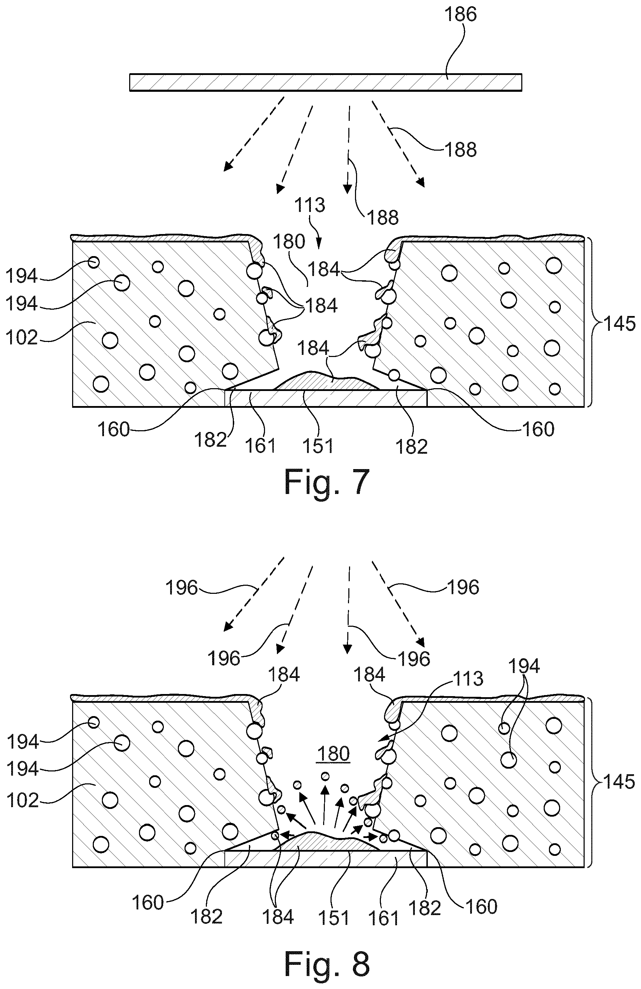

**Figure 7** and **Figure 8** illustrate cross-sectional views of structures obtained during carrying out a method of manufacturing a component carrier 100 with a laser blind hole 113 by a laser shot treatment and by subsequently filling the laser blind hole 113 at least partially with electrically conductive filling medium 184 according to an exemplary embodiment of the invention.

Figure 7 again illustrates the process of sputtering, whereas Figure 8 illustrates the the plasma-induced back-sputtering, see reference sign 196. As shown in Figure 7, shadow areas are formed after sputtering on the via sidewalls 100 and into the wedges 182. As shown, the electrically insulating layer structure 102 comprises filler particles 194 which partially delimit the tapering section 180 and/or the wedges 182. These phenomena may reduce the opportunity to properly fill the blind hole 113 with electrically conductive filling medium 184. As indicated in Figure 8, back-sputtering may re-arrange the previously sputtered material within the blind hole 113 and may in particular also fill at least part of the wedges 182 with the electrically conductive filling medium 184. This prevents the formation of undesired voids in an interior of an electrically conductive filling medium 184, a plating layer 146 and a further electrically conductive structure 148 filling the blind hole 113.

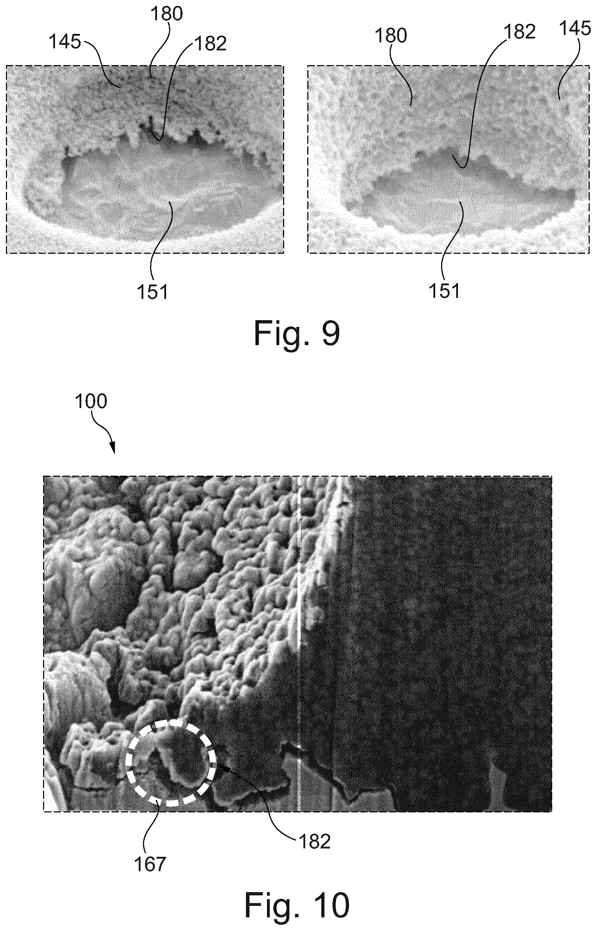

**Figure 9** is a three-dimensional view showing the geometry of a via bottom 151 after a wet desmear process following laser drilling.

As shown in Figure 9, circumferential wedges 182 may be formed at a bottom 151 of a blind hole 113 below a tapering portion 180. These wedges 182 are improperly filled with electrically conductive filling medium 184 during a mere sputtering process.

**Figure 10** illustrates a higher deposition rate of an electrically conductive filling medium 184 in wedges 182 of a blind hole 113 due to a combination of sputtering and back-sputtering. As seen in a detail 167 of Figure 10, the deposition rate in the wedges 182 may be significantly improved by back-sputtering following sputtering. As a result, the electric performance of the manufactured component carrier 100 may be significantly improved.

It should be noted that the term "comprising" does not exclude other elements or steps and the "a" or "an" does not exclude a plurality. Also, elements described in association with different embodiments may be combined.

It should also be noted that reference signs in the claims shall not be construed as limiting the scope of the claims.

Implementation of the invention is not limited to the preferred embodiments shown in the figures and described above. Instead, a multiplicity of variants is possible according to the invention as defined by the appended claims even in the case of fundamentally different embodiments.

## Claims

1. A method of manufacturing a component carrier (100), wherein the method comprises:
laminating a stack (145) comprising at least one electrically conductive layer structure (152, 161) and/or at least one electrically insulating layer structure (102);
forming a blind hole (113) with an exterior tapering section (180) in the stack (145);
cleaning the blind hole (113) and thereby forming wedges (182) in a bottom portion of the blind hole (113);
thereafter sputtering a filling medium (184), in particular an electrically conductive filling medium (184), into the blind hole (113);
the method being **characterized by** the step of:
back-sputtering at least part of the sputtered filling medium (184) by dry etching or by sputtering with an inverse voltage, so as to at least partially fill the wedges (182).

2. The method according to claim 1, wherein the method comprises forming the tapering section (180) by laser drilling.

3. The method according to one of the preceding claims, wherein the method comprises carrying out the cleaning by a desmear process.

4. The method according to one of the preceding claims, wherein the method comprises carrying out the cleaning by a wet desmear process.

5. The method according to one of the preceding claims, wherein the method comprises carrying out the back-sputtering by a plasma treatment.

6. The method according to one of the preceding claims, wherein the method comprises carrying out the back-sputtering by sputtering with an inverse negative voltage.

7. The method according to one of the preceding claims, wherein the method comprises carrying out multiple alternating sequences of sputtering and back-sputtering.

8. The method according to one of the preceding claims, wherein the method comprises back-sputtering at least part of the sputtered electrically conductive filling medium (184) so as to at least partially cover walls of the stack (145), which walls delimit the tapering section (180).

9. The method according to one of the preceding claims, wherein the method comprises carrying out the sputtering so that the electrically conductive filling medium (184) has a convex shape on a bottom (151) of the blind hole (113) after the sputtering.

10. The method according to one of the preceding claims, wherein the method comprises carrying out a treatment of a bottom (151) of the blind hole (113), in particular an etching treatment, for creating a concave surface at the bottom (151) of the blind hole (113).

## Patentansprüche

1. Verfahren zum Herstellen eines Bauteilträgers (100), wobei das Verfahren umfasst:
Laminieren eines Stapels (145), der mindestens eine elektrisch leitfähige Schichtstruktur (152, 161) und/oder mindestens eine elektrisch isolierende Schichtstruktur (102) umfasst;
Bilden eines Sacklochs (113) mit einem sich verjüngenden Außenabschnitt (180) in dem Stapel (145);
Reinigen des Sacklochs (113) und dadurch Bilden von Keilen (182) in einem Bodenabschnitt des Sacklochs (113);
danach Sputtern eines Füllmediums (184), insbesondere eines elektrisch leitfähigen Füllmediums (184), in das Sackloch (113);
wobei das Verfahren durch folgenden Schritt gekennzeichnet ist:
Rücksputtern zumindest eines Teils des gesputterten Füllmediums (184) durch Trockenätzen oder durch Sputtern mit einer inversen Spannung, um die Keile (182) zumindest teilweise zu füllen.

2. Verfahren nach Anspruch 1, wobei das Verfahren ein Bilden des sich verjüngenden Abschnitts (180) durch Laserbohren umfasst.

3. Verfahren nach einem der vorhergehenden Ansprüche, wobei das Verfahren ein Durchführen der Reinigung durch einen Entschmierungsprozess umfasst.

4. Verfahren nach einem der vorhergehenden Ansprüche, wobei das Verfahren ein Durchführen der Reinigung durch einen Nassentschmierungsprozess umfasst.

5. Verfahren nach einem der vorhergehenden Ansprüche, wobei das Verfahren ein Durchführen des Rücksputterns durch eine Plasmabehandlung umfasst.

6. Verfahren nach einem der vorhergehenden Ansprüche, wobei das Verfahren ein Durchführen des Rücksputterns durch Sputtern mit einer inversen negativen Spannung umfasst.

7. Verfahren nach einem der vorangehenden Ansprüche, wobei das Verfahren ein Durchführen mehrerer abwechselnder Sequenzen von Sputtern und Rücksputtern umfasst.

8. Verfahren nach einem der vorhergehenden Ansprüche, wobei das Verfahren ein Rücksputtern von zumindest einem Teil des gesputterten elektrisch leitfähigen Füllmediums (184) umfasst, um Wände des Stapels (145) zumindest teilweise abzudecken, wobei die Wände den sich verjüngenden Abschnitt (180) begrenzen.

9. Verfahren nach einem der vorhergehenden Ansprüche, wobei das Verfahren ein Durchführen des Sputterns so umfasst, dass das elektrisch leitfähige Füllmedium (184) nach dem Sputtern eine konvexe Form auf einem Boden (151) des Sacklochs (113) aufweist.

10. Verfahren nach einem der vorhergehenden Ansprüche, wobei das Verfahren ein Durchführen einer Behandlung eines Bodens (151) des Sacklochs (113), insbesondere einer Ätzbehandlung, zum Erzeugen einer konkaven Oberfläche an dem Boden (151) des Sacklochs (113) umfasst.

## Revendications

1. Procédé de fabrication d'un support de composant (100), dans lequel le procédé comprend :
la stratification d'un empilement (145) comprenant au moins une structure de couche électroconductrice (152, 161) et/ou au moins une structure de couche électro-isolante (102) ;
la formation d'un trou borgne (113) avec une section effilée extérieure (180) dans la pile (145) ;
le nettoyage du trou borgne (113) et ainsi la formation de coins (182) dans une partie inférieure du trou borgne (113) ;
la pulvérisation ensuite d'un milieu de remplissage (184), en particulier un milieu de remplissage électriquement conducteur (184), dans le trou borgne (113) ;
le procédé étant **caractérisé par** l'étape de :
La pulvérisation par l'arrière d'au moins une partie du milieu de remplissage pulvérisé (184) par gravure à sec ou par pulvérisation avec une tension inverse, de manière à remplir au moins partiellement les coins (182).

2. Procédé selon la revendication 1, dans lequel le procédé comprend la formation de la section conique (180) par perçage laser.

3. Procédé selon l'une des revendications précédentes, dans lequel le procédé comprend la réalisation du nettoyage par un procédé de dégraissage.

4. Procédé selon l'une des revendications précédentes, dans lequel le procédé comprend la réalisation du nettoyage par un procédé de dégraissage humide.

5. Procédé selon l'une quelconque des revendications précédentes, dans lequel le procédé comprend la réalisation de la pulvérisation cathodique par un traitement au plasma.

6. Procédé selon l'une quelconque des revendications précédentes, dans lequel le procédé comprend la réalisation de la pulvérisation cathodique à contre-courant par pulvérisation cathodique avec une tension négative inverse.

7. Procédé selon l'une des revendications précédentes, dans lequel le procédé comprend l'exécution de multiples séquences alternées de pulvérisation et de pulvérisation arrière.

8. Procédé selon l'une quelconque des revendications précédentes, dans lequel le procédé comprend la pulvérisation arrière d'au moins une partie du milieu de remplissage électroconducteur pulvérisé (184) de manière à recouvrir au moins partiellement des parois de la pile (145), lesquelles parois délimitent la section conique (180).

9. Procédé selon l'une des revendications précédentes, dans lequel le procédé comprend la réalisation de la pulvérisation cathodique de sorte que le milieu de remplissage électriquement conducteur (184) a une forme convexe sur un fond (151) du trou borgne (113) après la pulvérisation cathodique.

10. Procédé selon l'une des revendications précédentes, dans lequel le procédé comprend la réalisation d'un traitement d'un fond (151) du trou borgne (113), en particulier un traitement de gravure, pour créer une surface concave au fond (151) du trou borgne (113).
